# EUROPEAN PATENT APPLICATION

(11) **EP 4 439 919 A2**
(43) Date of publication of application: **02.10.2024**
(21) Application number: 24162618.3
(22) Date of filing: 11.03.2024
(51) Int. Cl.: H02J 7/00, G01R 31/3835, G01R 31/396

(54) **CELL NUMBER DETERMINATION CIRCUIT, CHARGE AND DISCHARGE CONTROL DEVICE AND BATTERY DEVICE PROVIDED WITH CELL NUMBER DETERMINATION CIRCUIT**

(30) Priority: 30.03.2023 JP 2023054504
(71) Applicant: ABLIC Inc., Kitasaku-gun, Nagano 389-0293 (JP)
(72) Inventor: FUKUCHI, Shinya, Nagano, 389-0293 (JP); SAITO, Hiroshi, Nagano, 389-0293 (JP); MURAKAWA, Keiichi, Nagano, 389-0293 (JP)
(74) Representative: Zabel, Julia Elisabeth

(57) **Abstract**

A cell number determination device, a charge and discharge control device (3), and a battery device with small circuit scale are provided. The cell number determination device includes: multiple differential amplifiers provided corresponding to multiple cells in a battery pack (2), of which the cell number is changeable, equipped with multiple cells connected in series; and multiple output circuits, provided corresponding to the differential amplifiers. An input differential pair of the differential amplifiers includes a heteropolar gate NMOS transistor (NM1, NM3) and an NMOS transistor (NM2, NM4).

## Description

### BACKGROUND

### Technical Field

The present invention relates to a cell number (number of cells) determination circuit, as well as a charge and discharge control device and a battery device provided with a cell number determination circuit.

### Description of Related Art

A cell number determination device including a voltage measurement unit, a voltage comparison unit, and a cell number determination unit is disclosed (for example, see Patent Document 1). The voltage measurement unit selects the i-th cell from multiple cells connected in series constituting one battery and measures the voltage value between a terminal connected to the (i-1)th cell, which is one cell higher than that cell, and the ground potential. The voltage comparison unit determines the presence or absence of the i-th cell by comparing the voltage value of the (i+1)th cell, which is one cell below the i-th cell, with the voltage value of the i-th cell. The cell number determination unit determines the cell number installed in the battery based on the comparison results of this voltage comparison unit.

### Related Art

### Patent Document

[Patent Document 1] Japanese Patent Application Laid-Open (JP-A) No. 2010-233359.

### SUMMARY

### Problems to be Solved

In a conventional cell number determination device, the circuit scale of the voltage measurement unit and the voltage comparison unit is large, which increases the circuit scale of the entire device.

The present invention has been made in view of the above problems, and an object of the present invention is to provide a cell number determination device, a charge and discharge control device, and a battery device that have a smaller circuit scale than conventional devices. Means for Solving the Problems

In order to solve the above problem, the cell number determination circuit of the present invention is a cell number determination circuit for determining a cell number in a battery pack equipped with multiple cells connected in series, including: multiple differential amplifiers provided corresponding to multiple cells in the battery pack of which the cell number is changeable; and multiple output circuits, provided corresponding to the differential amplifiers. An input differential pair of the differential amplifiers includes a heteropolar gate NMOS transistor and an NMOS transistor.
Further, the charge and discharge control device and the battery device according to the present invention include the cell number determination circuit.

In one embodiment, in the input differential pair of the differential amplifiers, the heteropolar gate NMOS transistor is connected to a maximum potential terminal of the battery pack, and the NMOS transistor is connected to a terminal to which the cells, of which the cell number is changeable, are connected.

In one embodiment, the differential amplifiers are configured such that a MOS transistor and a constant current source on the heteropolar gate NMOS transistor side are made common.

In one embodiment, a charge and discharge control device includes multiple input ports to which multiple terminals of the battery pack are connected; the above-mentioned cell number determination circuit, which determines a cell number in the battery pack based on voltages of a port corresponding to multiple cells, of which the number is changeable, among the input ports and a maximum potential terminal of the battery pack. The charge and discharge control device controls charging and discharging of the battery pack based on voltages of the input ports and an output signal of the cell number determination circuit.

In one embodiment, a battery device includes: a battery pack, equipped with multiple cells connected in series; the above-mentioned charge and discharge control device; and a charge control FET and a discharge control FET, which are connected in series with the battery pack between external terminals.

### Effects

The present invention is capable of providing a cell number determination device, a charge and discharge control device, and a battery device with small circuit scale.

### BRIEF DESCRIPTION OF THE DRAWINGS

FIG. 1 is a block diagram illustrating the charge and discharge control device and the battery device provided with the cell number determination circuit of this embodiment.
FIG. 2 is a block diagram illustrating an example in which a battery with the cell number reduced is connected to the battery device of this embodiment.
FIG. 3 is a block diagram illustrating another example of the charge and discharge control device of this embodiment.

### DESCRIPTION OF THE EMBODIMENTS

Hereinafter, a cell number determination circuit, as well as a charge and discharge control device and a battery device provided with a cell number determination circuit related to the present invention are described.

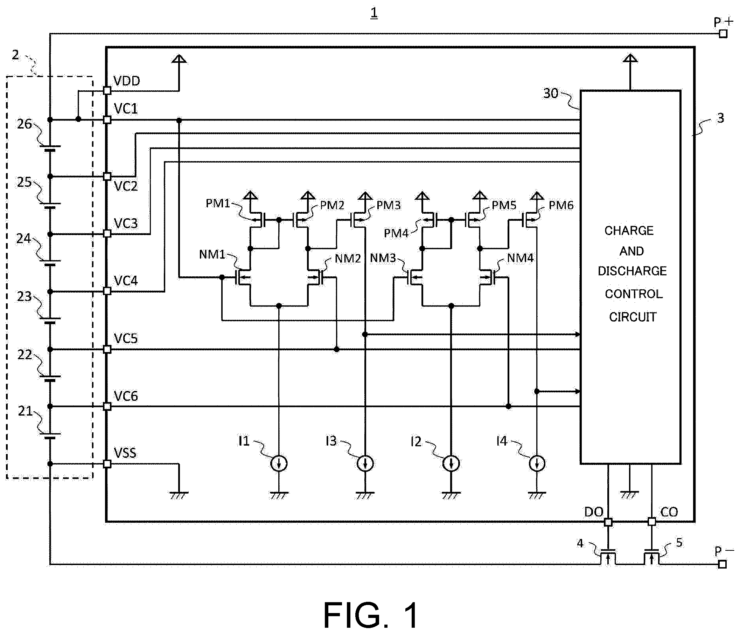

FIG. 1 is a block diagram illustrating the charge and discharge control device and the battery device provided with the cell number determination circuit of this embodiment.
The battery device 1 includes a charge and discharge control device 3, a battery pack 2 of six-series cell, which is an example of multiple cells connected in series, a discharge control FET 4, a charge control FET 5, an external terminal P+, and an external terminal P-. The battery pack 2 includes six cells 21 to 26 connected in series.

The charge and discharge control device 3 includes a charge and discharge control circuit 30, PMOS transistors PM1 to PM6, heteropolar gate NMOS transistors NM1 and NM3, NMOS transistors NM2 and NM4, constant current sources I1 to I4, a power supply terminal VDD, a ground terminal VSS, input ports VC1 to VC6, and output ports CO and DO. The cell number determination circuit includes the PMOS transistors PM1 to PM 6, the heteropolar gate NMOS transistors NM1 and NM3, the NMOS transistors NM2 and NM4, and the constant current sources I1 to I4.

The battery pack 2, the discharge control FET 4, and the charge control FET 5 are connected in series between the external terminal P+ and the external terminal P-. The cells 21 to 26 of the battery pack 2 are connected to the power supply terminal VDD, the input ports VC1 to VC6, and the ground terminal VSS of the charge and discharge control device 3, respectively. The gate of the discharge control FET 4 is connected to the output port DO of the charge and discharge control device 3. The gate of the charge control FET 5 is connected to the output port CO of the charge and discharge control device 3.

The cell number determination circuit includes a first cell detection circuit that detects the presence or absence of the cell 22, that is, whether or not it is a four-series cell, and a second cell detection circuit that detects the presence or absence of the cell 21, that is, whether or not it is a five-series cell.

The first cell detection circuit includes the PMOS transistors PM1, PM2, and PM3, the heteropolar gate NMOS transistor NM1, the NMOS transistor NM2, and the constant current sources I1 and I3.

The differential amplifier includes the PMOS transistors PM1 and PM2, the heteropolar gate NMOS transistor NM1, the NMOS transistor NM2, and the constant current source I1. The output circuit includes the PMOS transistor PM3 and the constant current source I3.

The gate of the heteropolar gate NMOS transistor NM1 is connected with the input port VC1 and receives the voltage VDD. The gate of the NMOS transistor NM2 is connected with the input port VC5 and receives the voltage VC5 of the input port VC5.

The input differential pair of the differential amplifier includes the heteropolar gate NMOS transistor NM1 and the NMOS transistor NM2. The threshold value Vth of the heteropolar gate NMOS transistor NM1 is 1.7 V, and the threshold value Vth of the NMOS transistor NM2 is 0.7 V Since these transistors have the same configuration except for the polarity of the gate, their temperature characteristics and offsets are equal, and the tendency of the variation of the threshold value Vth is also equal. Thus, the difference between the threshold values Vth of these transistors may be set to 1.0 V with high accuracy. That is, the differential amplifier may detect a difference within 1.0 V of the input voltage without providing an offset to the input differential pair.

The second cell detection circuit includes the PMOS transistors PM4, PM5, and PM6, the heteropolar gate NMOS transistor NM3, the NMOS transistor NM4, and the constant current sources I2 and I4.

The differential amplifier includes the PMOS transistors PM4 and PM5, the heteropolar gate NMOS transistor NM3, the NMOS transistor NM4, and the constant current source I2. The output circuit includes the PMOS transistor PM6 and the constant current source I4.

The gate of the heteropolar gate NMOS transistor NM3 is connected with the input port VC1 and receives the voltage VDD. The gate of the NMOS transistor NM4 is connected with the input port VC6 and receives the voltage VC6 of the input port VC6.

The input differential pair of the differential amplifier includes the heteropolar gate NMOS transistor NM3 and the NMOS transistor NM4. The threshold value Vth of the heteropolar gate NMOS transistor NM3 is 1.7 V, and the threshold value Vth of the NMOS transistor NM4 is 0.7 V. Since these transistors have the same configuration except for the polarity of the gate, their temperature characteristics and offsets are equal, and the tendency of the variation of the threshold value Vth is also equal. Thus, the difference between the threshold values Vth of these transistors may be set to 1.0 V with high accuracy. That is, the differential amplifier may detect a difference within 1.0 V of the input voltage without providing an offset to the input differential pair.

In the charge and discharge control circuit 30, the first to sixth input ports are connected with the input ports VC1 to VC6, receive respective terminal voltages, and monitors the voltage of each cell. Further, in the charge and discharge control circuit 30, the first cell number detection terminal is connected with the output port of the first cell detection circuit, the second cell number detection terminal is connected with the output port of the second cell detection circuit, and the cell number of the battery pack is detected.

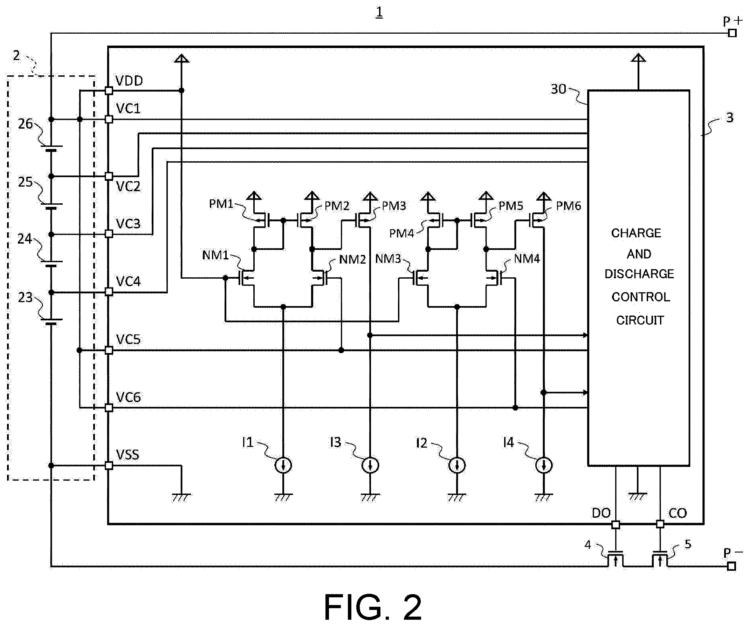

FIG. 2 is a block diagram illustrating an example in which a battery pack 2 with the cell number reduced to four is connected to the battery device of this embodiment. Since the configuration is the same as in FIG. 1 except for the connection between the battery pack 2 and the charge and discharge control device 3, the description is omitted.

In the battery pack 2, since the cell 21 and the cell 22 are reduced, each output port is connected to the positive terminal of the cell 26, and thus the voltage VDD is output. In the charge and discharge control device 3, the input ports VC5 and VC6 receives the voltage VDD, and thus the gates of the NMOS transistors NM2 and NM4 receive the voltage VDD.

The operation of the cell number determination circuit of the charge and discharge control device 3 of this embodiment is described. Here, the voltage of each cell is assumed to be 3V.

First, a case in which a six-series cell battery pack 2 is connected to the charge and discharge control device 3 as illustrated in FIG. 1 is described.

The gate of the heteropolar gate NMOS transistor NM1 of the first cell detection circuit receives the voltage VDD, and the gate of the NMOS transistor NM2 receives the voltage VC5 of the input port VC5. The voltage VDD is 18V and the voltage VC5 is 6V Thus, the first cell detection circuit outputs an L level signal from the output port indicating that the cell is connected. Similarly, the second cell detection circuit also outputs an L level signal from the output port.

In the charge and discharge control circuit 30, since the first cell number detection terminal and the second cell number detection terminal receive the L level signal, it is determined that the connected battery pack 2 is a six-series cell.

Next, a case in which a four-series cell battery pack 2 is connected to the charge and discharge control device 3 as illustrated in FIG. 2 is described.

The gates of the heteropolar gate NMOS transistor NM1 and the NMOS transistor NM2 of the first cell detection circuit receive the voltage VDD. At this time, the threshold value Vth of the heteropolar gate NMOS transistor NM1 is 1.7 V, and the threshold value Vth of the NMOS transistor NM2 is 0.7 V Although the input differential pair receives the same voltage VDD, due to the difference in the threshold value Vth, the current flowing through the NMOS transistor NM2 is larger than the current flowing through the PMOS transistor PM2.

Thus, the first cell detection circuit outputs an H level signal from the output port indicating that the cell is not connected. Similarly, the second cell detection circuit also outputs an H level signal from the output port.

In the charge and discharge control circuit 30, since the first cell number detection terminal and the second cell number detection terminal receive the H level signal, it is determined that the connected battery pack 2 is a four-series cell.

As described above, in the cell number determination circuit of this embodiment, since the input differential pair of the differential amplifier of the cell detection circuit includes the heteropolar gate NMOS transistor and the NMOS transistor, the presence or absence of a cell may be detected with high accuracy despite being a simple circuit.

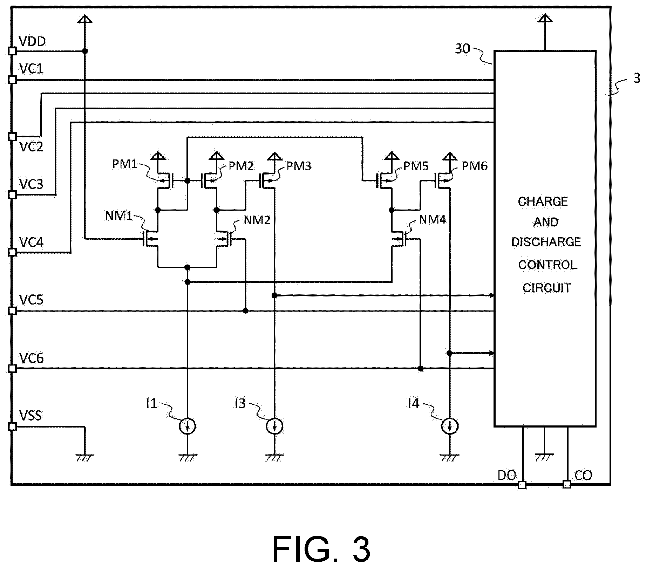

FIG. 3 is a block diagram illustrating another example of the charge and discharge control device 3 of this embodiment.

The charge and discharge control device 3 in FIG. 3 is configured such that the PMOS transistor PM4, the heteropolar gate NMOS transistor NM3, and the constant current source I2 of the second cell detection circuit and the PMOS transistor PM1, the heteropolar gate NMOS transistor NM1, and the constant current source I3 of the first cell detection circuit are made common, that is, the MOS transistor and the constant current source on the heteropolar gate NMOS transistor NM3 side are made common, thereby reducing the number of element.

The operation of the circuit is the same as that of the charge and discharge control device 3 in FIG. 1, so the description thereof is omitted.

The charge and discharge control device 3 configured in this manner may be configured with a minimum rise in the number of elements even if the number of cell number detection circuits is increased.

Although the embodiment of the present invention has been described above, the present invention is not limited to the above embodiment, and various changes may be made within the range without departing from the spirit of the present invention.
For example, although the configuration is described as having a first cell detection circuit and a second cell detection circuit for a battery pack of six-series cell to four-series cell, the cell number in the battery pack and the cell number capable of being increased or decreased, i.e., a cell number changeable (adjustable) range are not limited to these, and thus, the number of cell detection circuits included in the cell number determination circuit is also not limited.

For example, the above-mentioned MOS transistor is an example of FET, and are not limited to MOS transistors. FETs other than MOS transistors, such as a junction FET (JFET) or a metal insulating film semiconductor FET (MISFET), may also be used. Moreover, although the charge and discharge control circuit described above is a circuit configured to be able to control both charging and discharging, a circuit that does not have one of the control functions may be applied. That is, the charge and discharge control circuit described above may be replaced with a charge control circuit or a discharge control circuit.

### [Reference Signs List]

1 Battery device
2 Battery pack
3 Charge and discharge control device
4 Discharge control FET
5 Charge control FET
30 Charge and discharge control circuit
PM1, PM2, PM3, PM4, PM5, PM6 PMOS transistor
NM1, NM3 Heteropolar gate NMOS transistor
NM2, NM4 NMOS transistor
I1, I2, I3, I4 Constant current source

## Claims

1. A cell number determination circuit for determining a cell number in a battery pack (2) equipped with a plurality of cells connected in series, comprising:
a plurality of differential amplifiers provided corresponding to a plurality of cells in the battery pack of which the cell number is changeable, the differential amplifiers each including an input differential pair; and
a plurality of output circuits provided corresponding to the plurality of differential amplifiers;
wherein an input differential pair of the differential amplifiers comprises a heteropolar gate NMOS transistor (NM1, NM3) and an NMOS transistor (NM2, NM4).

2. The cell number determination circuit according to claim 1, wherein
in the input differential pair of the differential amplifiers, the heteropolar gate NMOS transistor is connected to a maximum potential terminal of the battery pack, and the NMOS transistor is connected to a terminal to which the cells, of which the number is changeable, are connected.

3. The cell number determination circuit according to claim 2, wherein
the plurality of differential amplifiers are configured such that a MOS transistor and a constant current source (I1, I2, I3, I4) on the heteropolar gate NMOS transistor side are made common.

4. A charge and discharge control device (3), comprising
a plurality of input ports to which a plurality of terminals of the battery pack are connected;
the cell number determination circuit according to any one of claims 1 to 3, which determines a cell number in the battery pack based on voltages of a port corresponding to a plurality of cells, of which the number is changeable, among the plurality of input ports and a maximum potential terminal of the battery pack,
wherein the charge and discharge control device controls charging and discharging of the battery pack based on voltages of the plurality of input ports and an output signal of the cell number determination circuit.

5. A battery device, comprising:
a battery pack, equipped with a plurality of cells connected in series;
the charge and discharge control device according to claim 4; and
a charge control FET and a discharge control FET, which are connected in series with the battery pack between external terminals.
